Europäisches Patentamt

European Patent Office

Office européen des brevets

(11) Veröffentlichungsnummer: **0 289 661**
**A2**

## (12) EUROPÄISCHE PATENTANMELDUNG

(21) Anmeldenummer: 87118299.4

(22) Anmeldetag: 10.12.87

(51) Int. Cl.4 **H01L 21/66 , H01L 21/205 ,**
**C23C 14/54 , C23C 16/52 ,**
**H01C 17/06 , G01R 27/30**

(30) Priorität: 28.03.87 DE 3710365

(43) Veröffentlichungstag der Anmeldung:
09.11.88 Patentblatt 88/45

(84) Benannte Vertragsstaaten:
AT BE CH DE FR GB IT LI LU NL SE

(71) Anmelder: **Messerschmitt-Bölkow-Blohm**
**Gesellschaft mit beschränkter Haftung**
**Robert-Koch-Strasse**
**D-8012 Ottobrunn(DE)**

(72) Erfinder: **Meyer, Meinhard, Dr.**
**Brockesstrasse 3**
**D-8000 München 83(DE)**
Erfinder: **Störmer, Oswald**
**Söhl Nr. 4**
**D-8201 Tuntenhausen(DE)**

(54) Verfahren zur reproduzierbaren Bildung von Materialschichten und/oder zur Behandlung von Halbleiter-Materialschichten.

(57) Zur reproduzierbaren Bildung von Material-schichten im Wege des Aufdampfend oder Zer-stäubens oder der chemischen Abscheidung usw. und/oder zur Behandlung von Materialschichten, insbesondere von Halbleiterschichten durch Diffusion oder Ionenimplantation, wobei während der Schichtbildung zumindest ein Parameter der Materialschicht gemessen und als Meßsignal in einer digitalen Auswerteschaltung zur On-Line-Steuerung des Schichtbildungsprozesses berücksichtigt wird, wird in bestimmten Zeitabständen kurzzeitig ein Prüfsignal mit vorgegebenem Verlauf oder Frequenzspektrum oder vorgegebener Frequenzfolge an die Materialschicht angelegt. In einem Prozeßrechner der digitalen Auswerteschaltung werden aus dem jeweiligen Prüfsignal (Stromsignal) und dem zugeordneten Meßsignal (Spannungssignal) zeitlich voneinander trennbare Impedanz-Anteile ermittelt, die untereinander abweichende Werte oder Wertebereiche von Zeitkonstanten und gegebenenfalls zusätzlich von Leitfähigkeiten aufweisen und die insgesamt kennzeichnend sind für den durch die sich bildende Schicht fließenden Strom, nämlich den Strom durch die homogenen Materialbereiche der Schicht (Intrinsik-Strom $i_2$), den über die Partikel-

Grenzflächen (Korngrenzen-Strom $i_3$) fließenden Strom und den über die Schichtoberfläche fließen-den Strom (Oberflächenstrom $i_1$).

FIG. 1a

## Verfahren zur reproduzierbaren Bildung von Materialschichten und/oder zur Behandlung von Halbleiter-Materialschichten

Die Erfindung betrifft ein Verfahren zur reproduzierbaren Bildung von Materialschichten im Wege des Aufdampfens oder Zerstäubens oder der chemischen Abscheidung usw. und/oder zur Behandlung von Materialschichten, insbesondere von Halbleiterschichten durch Diffusion oder Ionenimplantation, wobei während der Schichtbildung zumindest ein Parameter der Materialschicht gemessen und als Meßsignal in einer digitalen Auswerteschaltung zur On-Line-Steuerung des Schichtbildungsprozesses berücksichtigt wird.

Elektrische, nichtstationäre, d. h. zeit-bzw. frequenzabhängige Meßmethoden mit einer definierten Änderung einer Größe im zu untersuchenden elektrischen System (z.B. Strom) und Messung einschließlich Auswertung des Meß-Signals (z. B. Spannung) als Funktion der Zeit bzw. Frequenz werden zur Aufklärung komplexer Reaktionen und Leitungsvorgänge in der Elektrochemie angewandt (Techniques of Electrochemistry, E. Yeager, A. J. Salkind, Wiley-Interscience, N.Y. 1972).

Anhand von Festkörperzellen konnte ferner mit Hilfe dieser Methoden die Trennung der Elektrodenreaktionen von den Leitungsvorgängen im Inneren des Festkörpers durchgeführt werden (M. Meyer et al., Solid State Ionics 9, 10 (1983), S 689 bis 694).

Die elektrische Leitung in Festkörpern wird einerseits durch die intrinsischen Eigenschaften (Stromfluß durch die homogenen Materialbereiche), den Dotierungsgrad und die Temperatur andererseits maßgeblich durch die Struktur (Gefüge), Morphologie und Herstellbedingungen des jeweiligen Materials bestimmt.

In der Dünnschichttechnik werden durch geringfügig abweichende Prozeßbedinungen bei dem jeweiligen Herstellverfahren dünne Schichten mit z. T. erheblichen Struktur-und Morphologieänderungen hergestellt, was mit großen Eigenschaftsänderungen wie Leitfähigkeit, Kapazität, Induktivität, Haftfestigkeit, Härte, Dichte, Verschleiß-, Oxidations-bzw. Korrosionsbeständigkeit usw. verbunden ist.

Derzeit sind aus der EP A2 00 33 507 Gleichstrommessungen bekannt, um die Schichtdicke und/oder die Strukturänderung von elektrisch leitfähigen Schichten on-line-artig zu bestimmen. Zur Bestimmung der Temperatur ist dabei ein Widerstandsthermometer vorgesehen. Dieses bekannte Verfahren eignet sich nur zur gleichstrombedingten Leitfähigkeitsbestimmung von elektrischen Leitern.

Aufgabe der Erfindung ist es, ein Verfahren der eingangs genannten Art zu schaffen, das es ermöglicht, während der Materialschichtbildung bzw. möglicht, während der Behandlung einzelner Material-Schichten, insbesondere von Halbleiter-Schichten, Kennwerte als Meßsignale zu ermitteln, die Aufschluß über die Struktur (Gefüge), über die Morphologie und über die Schichtdicke geben, wobei durch Auswertung dieser Kennwerte on-line-artig auf den Prozeß steuernd oder regelnd eingewirkt werden soll.

Diese Aufgabe wird erfindungsgemäß dadurch gelöst, daß im bestimmten Zeitabständen kurzzeitig ein Prüfsignal mit vorgegebenem Verlauf oder Frequenzspektrum oder vorgegebener Frequenzfolge an die Materialschicht angelegt wird, daß in einem Prozeßrechner der digitalen Auswerteschaltung aus dem jeweiligen Prüfsignal (Stromsignal) und dem zugeordneten Meßsignal (Spannungssignal) zeitlich voneinander trennbare Impedanz-Anteile ermittelt werden, die untereinander abweichende Werte oder Wertebereiche von Zeitkonstanten und gegebenenfalls zusätzlich von Leitfähigkeiten aufweisen und die insgesamt kennzeichnend sind für den durch die homogenen Materialbereiche (Partikel) fließenden Strom (Intrinsik-Strom), den über den Partikel-Grenzflächen (Korngrenzen-Strom) fließenden Strom und den über die Schichtoberflächen fließenden Strom (Oberflächenstrom).

Schichten aus gleichem Material und gleicher Dicke, jedoch unterschiedlicher Struktur (Gefüge) und Morphologie, unterscheiden sich stark in ihrer elektrischen Impedanz. Die Gesamtimpedanz einer Schicht setzt sich hauptsächlich aus der Intrinsik-, Korngrenzen und Oberflächenimpedanz zusammen, wobei die Intrinsik-Impedanz den Stromfluß durch das Innere der Partikel (Eigenleitfähigkeit), die Korngrenzenimpedanz den Stromfluß über die Partikel-Randflächen unter Berücksichtigung der Grenzflächen-Anreicherungen und die Oberflächenimpedanz den Stromfluß über die Oberflächen des Partikelverbandes (Schicht) berücksichtigt. Durch Anwendung nichtstationärer, elektrischer Meßmethoden können die Anteile der Gesamtimpedanz mit unterschiedlichen Zeitkonstanten bzw. Leitfähigkeiten zeitlich separiert werden. Beispielhaft werden hier als Meßmethoden galvanostatische Einschalt-bzw.Pulsmessungen und die Impedanzmessung über ein Frequenzspektrum genannt.

Bei der galvanostatischen Einschaltmessung wird der Schicht während der Beschichtungszeit in regelmäßigen Abständen ein definierter Stromimpuls aufgezwungen. Die sich jeweils einstellende Spannung als Funktion der Zeit zeigt die unterschiedlichen charakteristischen Leitungsvorgänge in der momentanen Schicht.

Durch eine elektronische Auswertung der sich aus dem zuvor beschriebenen Ablauf ergebenden Meß-Signale und die Aufzeichnung bestimmter, für den jeweiligen Schichtzustand charakteristischer Größen über der Beschichtungszeit, kann auf die Beschichtungsgüte geschlossen werden.

Bei einer Auswertung in einem Prozeßrechner wird mit den aufgezeichneten Daten der Prozeß gesteuert bzw. geregelt.

Bei der Wechselstrommessung über ein Frequenzspektrum lassen sich die unterschiedlichen Leitungsvorgänge in der momentanen Schicht z. B. durch verschiedene Ortskurven im Realteil-Imaginärteildiagramm darstellen.

Die Schicht wird in regelmäßigen zeitlichen Abständen mit einem Frequenzspektrum beaufschlaft. Des weiteren wird eine elektronische Auswertung z.B. über eine FFT-Analyse (Fast-Fourier-Transformation) durchgeführt. Die Aufzeichnung bestimmter charakteristischer Größen über der Beschichtungszeit liefert Werte, die auf die Beschichtungsggüte schließen lassen.

Bei einer Auswertung in einem Prozeßrechner kann mit den aufgezeichneten Daten ebenfalls der Prozeß gesteuert bzw. geregelt werden.

Die Meß-und Auswertezeit für die Charakterisierung des momentanen Schichtzustandes ist in beiden Fällen gering gegenüber der Beschichtungszeit.

Für die praktische Anwendung ist ggf. eine elektrische Abschirmung der Impedanzmeßzelle erforderlich.

Die Bestimmung der Prozeßtemperatur erfolgt nach der vorliegenden Erfindung über ein Thermoelementepaar. Die Referenztemperatur hierzu kann auf verschiedene Weise ermittelt werden.

Die Meßmethode ist für die On-Line-Messung an wachsenden Schichten geeignet, die mittels Aufdampfen (durch Elektronenstrahl oder indirektes Aufheizen) und Sputtern (durch magnetfeldunterstützes Hochfrequenz-oder Gleichstromkathodenzerstäuben) hergestellt werden.

Weitere wichtige Anwendung für die On-Line-Messung an wachsenden Schichten sind die chemische Abscheidung von Schichten aus der Gasphase (chemical vapor deposition, CVD) und aus der flüssigen elektrolytischen Phase durch Abscheidung von Metallen, Legierungen und Dispersionen.

Wegen des ausgeprägten Schichtgefüges, die durch die Körnung hervorgerufen wird, eignen sich gespritzte Schichten gut für die Charakterisierung mittels dieser Meßmethoden. Als Spritzverfahren kommen Flamm-, Lichtbogen-, Plasma-und Detonationsspritzen in Frage.

Beim Abtragen von Schichten mit und ohne Reaktivgasen, die zudem noch auf verschiedene Arten zusätzlich aktiviert sein können, z. B. im Plasma, kann diese Meßmethode zur Charakterisierung des jeweiligen Oberflächen-und Schichtzustandes während des Abtrageverfahrens eingesetzt werden.

Das Gleiche gilt, wenn der eben genannte Abtragungsvorgang nur kurz auf das beschichtete oder unbeschichtete Werkstück bzw. Bauelement einwirkt, z. B. bei der Plasmabehandlung von Oberflächen zu deren Weiterverarbeitung.

Die instationären Meßmethoden werden grundsätzlich nicht durch eine Mindestleitfähigkeit der Schicht begrenzt. Vielmehr lassen sich damit auch elektrisch hochisolierende Schichten, sowie eine Folge von Schichten verschiedener Leitfähigkeit während ihrer Bildung charakterisieren.

Über den eigentlichen Beschichtungsprozeß hinausgehend wird mittels dieser Meßmethoden zusätzlich oder alternativ die gezielte Behandlung oder Veränderung der Oberfläche während eine Plasma-, Implantations-und Ionenstrahlbehandlung erfaßt. So ist es z.B. zweckmäßig, mit diesem Verfahren direkt die Leitungsänderung und damit verbunden das Dotierungsprofil von implantierten Halbleiterschichten zu charakterisieren. Das Gleiche gilt für die direkte Messung der Kapazität von dielektrischen Schichten auf Fremd-oder Originalsubstraten und für die direkte Messung der magnetischen Induktion von magnetischen Schichten.

Elektrisch isolierende Schichten, z.B. in Form von $SiO_2$ (Quarz) haben in der Elektronik eine besondere Bedeutung. In zunehmendem Maße werden sie auch als funktionelle Schichte bei Werkstoffen angewandt, wo sie als Verschleißschutz-, Korrosionsschutz-, Oxidationsschutzschichten, oder als Diffusionssperr-, bzw. Haftvermittlerschichten dienen.

Auch ist als erfindungsgemäße Meßverfahren bei entsprechender Auslegung der Sensoren für die Messung der Schichteigenschaften von leitenden Schichten geeignet.

Es können in einer Schicht Leitungsvorgänge mit unterschiedlichen Zeitkonstanten bzw. Leitfähigkeiten (Beweglichkeiten) durch Anwendung instationärer elektrischer Meßmethoden zeitlich separiert dargestellt werden.

Die unterschiedlichen realen und imaginären Leitungsvorgänge und damit Impedanzen charakterisieren den Schichtzustand, der durch die Struktur (Gefüge), die Morphologie und Dicke bei einem bestimmten Schichtmaterial gegeben ist.

Bei galvanostatischen Einschalt-bzw. Impulsmessungen, bei denen die Zeitglied-bedingte Verzögerung (Filter-Wirkung) ausgewertet wird, wird die Struktur-, Morphologie-und Dickenänderung der wachsenden Schicht durch Änderung der zu messenden Spannungs-Zeit-Kurven (Meß-Signal) angezeigt.

Die elektronische Auswertung der sich ergebenden Meß-Signale und das Aufzeigen charakteristischer Größe (Impedanzwerte) daraus über der Beschichtungszeit ermöglichen einen Rückschluß auf die Beschichtungsgüte.

Bei den Impedanzmessungen an der wachsenden Schicht über ein Frequenzspektrum (Ortskurve) kann die Steuerung mit den verschiedenen Frequenzen zur gleichen Zeit über ein Rauschsignal bzw. Pseudo-Rauschsignal oder nacheinander über einen Oszillator mit durchstimmbarer Frequenz erfolgen.

Die Auswertung erfolgt über einen Vergleich des Prüf-und des Meßsignales. Die Änderung der Struktur (Gefüge), Morphologie und Schichtdicke wird beim den Impedanzmessungen durch Lageveränderung der Ortskurven im Real-Imaginär-Diagramm angezeigt.

Eine elektronische Auswertung erfolgt hierbei z.B. über eine FFT-Analyse (Fast-Fourier-Transformation) mit einer Umrechnung in die charakteristischen Größen. Auch hier bietet das Aufzeigen charakteristischer Größen daraus über der Beschichtungszeit einen Rückschluß auf die Beschichtungsgüte.

In beiden Fällen kann die Dickenänderung der Schicht leicht von einer Struktur(Gefüge-), bzw. Morphologieänderung getrennt werden. Die Meßanordnung entspricht der üblichen Zwei-bzw. Vier-Punktmeßmethode, wobei durch die Anordnung der Elektroden unter, in bzw. auf der Schicht der Wert der vorhandenen Widerstände, Kapazitäten und Induktivitäten festgelegt und bestimmt wird.

Um beispielsweise bei einem elektrisch stark isolierenden Schichtmaterial einen Durchgangswiderstand (Intrinsik-Widerstand) als Charakteristikum erfassen zu wollen, müssen die Elektroden nahe zusammen angebracht bzw. aufstrukturiert werden.

Sollen dagegen relativ niederohmige Schichtwiderstände ausgewertet werden, ist es zweckmäßig, die Elektroden in einer weiteren Entfernung anzubringen bzw. aufzustruktieren.

Ferner richtet sich die Anordnung der Elektroden nach dem zu charakterisierenden Schichteffekt; soll z.B. die Keimbildung und das Zusammenwachsen der Keime charakterisiert werden, so müssen flache Elektroden auf dem Substrat auflithographiert werden.

Ein Umschalten auf eine andere Elektrodenanordnung während der Schichtbildung zur Charakterisierung weiterer Schichteffekte ist ebenfalls möglich.

Liegt dagegen eine Schicht vor, deren kapazitiver Anteil besonders vergrößert werden muß, um es als Charakteristikum für die Schichtbildung heranziehen zu können, sind z. B. die Elektroden großflächiger anzuordnen.

In der Praxis wird zweckmäßigerweise so vorgegangen, daß während der Herstellung eine Schicht, die die gewünschten Eigenschaften unter definierten Prozeßbedingungen erreicht, Referenzmessungen on-line-artig durchgeführt, gespeichert und ausgewertet werden. Die gespeicherten Daten, die während der Herstellung dieser Musterschicht anfallen, werden nach ensprechender Aufarbeitung zur Prozeßkontrolle herangezogen.

Bei dem erfindungsgemäßen Verfahren ist es möglich, die Meßwerte, aus denen auf die Schichteigenschaften geschlossen werden soll, z. B. telemetrisch zu übertragen.

Gemäß weiterer Ausbildung sind folgende Merkmale vorgesehen:

Die Übertragung der Meßdaten erfolgt über leitende Verbindungen zu einem Auswertegerät.

Es erfolgt eine unabhängige Montage des Meßsystems am Substrathalter, das damit frei beweglich ist.

Die Übertragung der Meßdaten erfolgt mittels eines Telemetrie-Systems zu einem Auswertegerät.Die Daten werden im sogenannten PCM-Verfahren übertragen.Hierbei erfolgt die Übertragung der Telemetrie-Daten mittels Hochfrequenz.Die Übertragung der Telemetrie-Daten kann auch mittels Infrarotsignalen erfolgen.

Die Übertragung der Telemetrie-Daten kann aber auch mittels induktiver oder kapazitiver Kopplung erfolgen.

Die Anbringung der Antenne für das jeweilige Übertragungsverfahren erfolgt mittels einer isolierten Vakuumdurchführung innerhalb der Vakuumkammer.

Die Anbringung der Antenne erfolgt für das jeweilige Übertragungsverfahren außerhalb der Vakuumkammer unter Ausnutzung entsprechender, nichtabschirmender Öffnungen der Kammer, wie z. B. Glasfenster.

Gemäß weiterer Ausbildung sind die Meßwertaufnehmer für die unterschiedlichen Prozesse wie folgt ausgelegt:

Der Meßwertaufnehmer ist in Form eines Fremdsubstrates, z. B. eines nichtleitenden Plättchens, oder in Form des Originalsubstrates, z.B. des jeweiligen Halbleitermaterials, ausgebildet und ist mit angebrachten bzw. auflithographierten Kontakten zur Abnahme der erwarteten Meßgrößen versehen.

Bei der Ermittlung von Abtragvorgängen ist der Meßwertaufnehmer mit einer Referenzschicht versehen, die der abzutragenden Schicht entspricht.

Zur Behandlung oder Veränderung der Oberfläche durch Plasma-, Implantations, und Ionenstrahlbehandlung wird das Referenzsubstrat, das dem zu behandelnden Material entspricht, eingesetzt.

Der Meßwertaufnehmer wird mit einer Referenzöffnung abgedeckt, die es ermöglicht, eine partielle Beschichtung bzw. Abtragung des Aufnehmers zu erreichen. Die Abdeckung hat keine leitende Verbindung zum Aufnehmer aufzuweisen.

Um einen störenden Einfluß des Plasmas bei dynamischen Prozessen, bei denen der Substrathalter nur jeweils kurzzeitig durch das Plasma bewegt wird, auf den Meßwert zu unterbinden, erfolgt die Messung dann ggf. außerhalb des direkten Plasmaeinflusses.

Der Sender ist zusammen mit den Meßwertaufnehmern und der Stromversorgung in Miniaturbauweise zu einem unabhängigen Meßsystem integriert.

Es erfolgt eine wärmeisolierte Montage des miniaturisierten Meßsystems am beweglichen Substrathalter.

Die Ausführung des Meßsystems erfolgt mit derartigen Materialien, daß keine Vakuumverunreinigung gegeben ist.

Die Ausführung des Meßsystems kann außerdem in der Art erfolgen, daß eine vakuumdichte Kapselung der Bauelemente gesichert ist.

Die Auswerte-und Sende-Elektronik des Meßsystems sind räumlich von den Meßwertaufnehmern getrennt.

Die Verbindung des Meßsystems mit den Meßwertaufnehmern erfolgt über feste, leitende Verbindungen.

Die Verbindung des Meßsystems mit den Meßwertaufnehmern erfolgt über lösbare Verbindungen, z.B. Federkontakte.

Aus den Signalen der Meßwertaufnehmer werden die beim HF-Sputtern auftretenden Frequenzen ausgefiltert.

Die Anregungssignale für die verschiedenen Meßverfahren werden im beweglichen Meßsystem autonom erzeugt.

Die Anregungssignale für die verschiedenen Meßverfahren können vom Empfangsteil gesteuert werden.

Zur Auswertung der Prüf-und Meß-Signale der Meßwertaufnehmer sind die folgenden Varianten vorgesehen:

Vom Meßsystem werden von den für die Auswertung erforderlichen Größen regelmäßige Abtastsignale aufgenommen und bis zur Übertragung, die im gleichen Takt abläuft, zwischengespeichert. Hierbei wird durch eine analoge Vorfilterung vor der Abtastung eine Beschneidung des Frequenzbandes derart durchgeführt, daß es nicht zu Aliasing-Fehlern bei der nachfolgenden Signalverarbeitung kommt.

Die abgetasteten Werte werden dann in der beschriebenen Weist in ein Auswertegerät übertragen.

Die eigentliche Signalverarbeitung im Auswertegerät wird durch einen Digitalfilteralgorithmus oder eine FFT-Analyse (Fast-Fourier-Transformation) gebildet.

Nach der Signalverarbeitung im Auswertegerät werden die zur Bestimmung der Schichteigenschaften berechneten Daten einem Prozeßrechner zugeführt, wobei dieser Prozeßrechner ein Teil des Auswertegerätes selbst sein kann.

Gemäß einer weiteren Ausbildung erfolgt eine schnelle Zwischenspeicherung einer so großen Menge von Abtastpaar-Werten der Prüf-und Meß-Signale im Meßsystem, wie es z.B. für die Darstellung eines Einschaltimpulses erforderlich ist.

Ein Vorteil ist dabei darin zu sehen, daß im Meßsystem die Signale in sehr großer Wiederholrate aufgenommen werden. Da dieses zugleich auch die Abtastfrequenz ist, wird dadurch eine große Bandbreite, insbesondere bei Impulsmessungen abgedeckt.

Die Übertragung zum Auswertegerät und die Signalverarbeitung erfolgen bezogen auf die Abtastrate nicht mehr in Echtzeit. Die Kenntnis der ursprünglichen Abtastrate im Meßsystem reicht zu einer Reproduktion der Meßgrößen aus.

Eine Auswertung z.B. im Bereich bis zu einer Sekunde ist gemessen an der Dauer des Beschichtungsvorganges immer noch schnell genug, um für diesen Vorgang eine On-Line-Regelung zu ermöglichen.

Die nächste mögliche Variante wird dadurch dargestellt, daß die Signalverarbeitung der abgetasteten Meßwerte direkt im beweglichen Meßsystem durchgeführt wird.

Über die genannten Übertragungsverfahren werden einem Auswertegerät bereits die Daten übermittelt, die zur Bestimmung der Schichteigenschaften erforderlich sind.

Die berechneten Daten werden einem Prozeßrechner zugeführt, der selbst ein Teil des Auswertegerätes sein kann.

Die Bestimmung der Prozeßtemperatur erfolgt über ein Thermoelementepaar. Die Referenztemperatur hierzu wird dabei dadurch ermittelt, daß eine relativ isotherme Fläche innerhalb oder außerhalb der Vakuumkammer als Referenzpunkt benutzt wird.

Die Temperaturkonstanthaltung, die innerhalb oder außerhalb des Meßsystems ausgebildet sein kann, erfolgt auf elektronischem Wege.

Bei zeitlich kurzen Beschichtungsvorgängen wird die dem Prozeß abgewandte Seite des Meßsystems unter Ausnutzung der thermischen Trägheit als Referenzpunkt benutzt.

Der Referenzpunkt wird durch eine zwangsgekühlte Fläche des Substrathalters gebildet.

Die Speisung des frei beweglichen Meßsystems mit Versorgungsspannung erfolgt entweder durch Zuführung der Spannung über Federkontakte, die am Substratträger angebracht sein können, durch Zuführung der Spannung über Solarzellen, die entweder über das Plasmaleuchten oder über zusätzliche Lichtquellen gespeist werden, oder durch Zuführung der Spannung über einen HF-Träger, der entweder aus dem HF-Spektrum des Beschichtungsvorganges oder aber aus einer zusätzlichen HF-Spule zur Verfügung gestellt wird.

Auch kann die Versorgung mit Spannung über Primär-Batterien oder wiederaufladbare Akkumulatoren erfolgen.

Die Darstellung der Ergebnisse der Meßverfahren erfolgt noch während des Prozeßverlaufes (on-line) auf einem Anzeigemedium, z. B. Bildschirm.

Die Berechnung der Differenz der On-Line-Ergebnisse und der gespeicherten Referenzkurven aus einem früheren Prozeßablauf sowie Anzeige dieser Differenz erfolgen ebenfalls auf einem Anzeigemedium, z.B. Bildschirm.

Die Kopplung der Meßverfahren mit einem Prozeßrechner erfolgt zum Zwecke der Prozeßkontrolle oder Prozeßsteuerung bzw. Prozeßregelung, z.B. durch Vergleich der On-Line-Ergebnisse des Meßverfahrens mit gespeicherten Referenzkurven aus einem früheren Prozeßablauf und Berechnung der Steuer-bzw. Regelgrößen für den Prozeß.

Weitere vorteilhafte Ausgestaltungen finden sich in den Unteransprüchen. Im folgenden wird die Erfindung anhand eines in den Figuren 1 bis 6 dargestellten Ausführungsbeispiels beschrieben.

Es zeigen:

Fig. 1a und 1b eine schematische Darstellung einer Vorrichtung zur Ermittlung von Materialschichtkennwerten,

Fig. 2 das Prüf-und Meßsignal bei einer galvanostatischen Einschaltmessung,

Fig. 3 das Prüfsignal und die errechnete Ortskurve bei einer Wechselstrommessung über ein Frequenzspektrum,

Fig. 4a bis 5b Muster-Materialschichtträger-Konfigurationen und

Fig. 6a bis 6c die schematische Partikelkonfiguration einer Materialschicht.

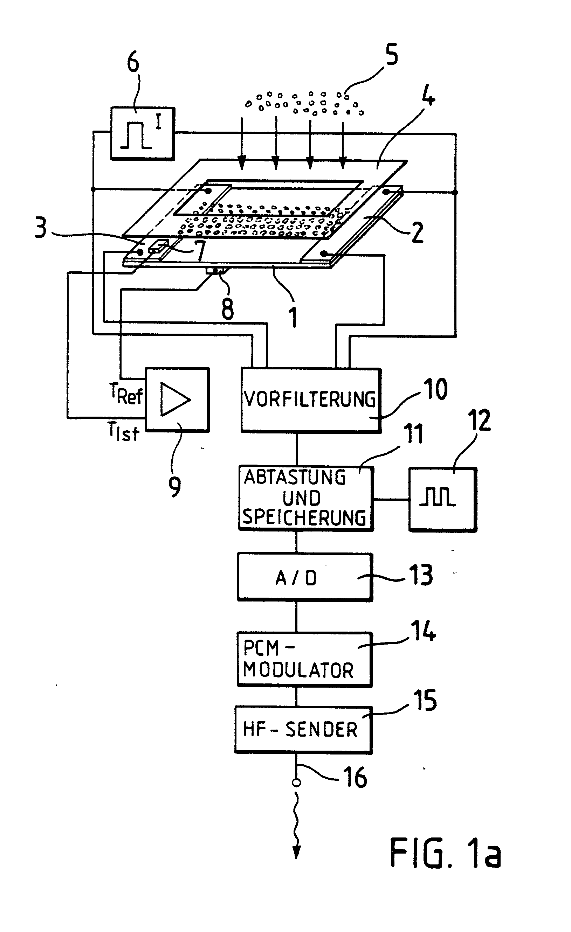

Gemäß Fig. 1a ist mit 1 ein Materialschichtträger bezeichnet, der an den seitlichen Enden Kontaktbereiche 2 und 3 aufweist. Dieser Materialschichtträger 1 ist Bestandteil einer Muster-Beschichtungsvorrichtung. Oberhalb des Materialschichtträgers befindet sich eine Maske 4. Auf dem Materialschichtträger 1 entstehen während des Aufdampfens, Zerstäubens oder chemischen Abscheidens Schichten mit charakteristischer Struktur, Gefüge und Morphologie, was in Figur 1a durch die Materialpartikel 5 angedeutet ist.

Mit 6 ist eine Prüf-Stromsignalquelle bezeichnet, die an die Kontaktflächen 2 und 3 angeschlossen ist. Mit 7 und 8 sind Temperatursensoren bezeichnet, die eine Referenztemperatur und eine Ist-Wert-Temperatur messen und einem Thermoverstärker 9 zuführen.

Mit 10 ist eine Vorfilterungsstufe bezeichnet, die störende Frequenzanteile aussiebt. Mit 11 ist eine Abtast-und Speichervorrichtung bezeichnet, die durch einen Taktgenerator 12 getaktet wird. Mit 12 und 13 ist ein Analog-Digitalwandler bezeichnet, dessen Ausgang mit einem PCM-Modulator 14 verbunden ist. Die Signale des PCM-Modulators werden einem HF-Sender 15 zugeführt, dessen Ausgangssignale über eine Antenne 16 abgestrahlt werden.

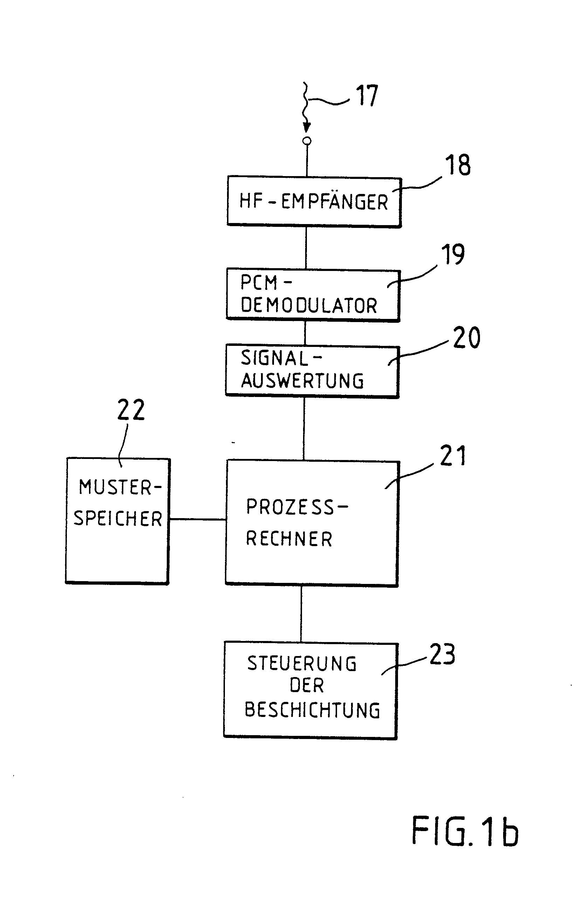

Gemäß Fig. 1b werden die entsprechend modulierten Meßsignale 17 von einem HF-Empfänger 18 empfangen und einem PCM-Demodulator 19 zugeführt. Eine Signalauswertung erfolgt in einer Signalauswertungsstufe 20. Die Ausgangssignale dieser Signalauswertungsstufe 20 werden einem Prozeßrechner 20 zugeführt. Der Prozeßrechner vergleicht die ständig gemessenen und verarbeiteten Ist-Wert-Daten mit Musterdaten, die in einem Musterspeicher 22 abgelegt sind. Der Prozeßrechner 21 erzeugt dann Steuerdaten für die Steuerung der Beschichtung in einer Prozeßsteuervorrichtung 23. Durch diese Prozeßsteuervorrichtung 23 kann beispielsweise eine Parameterbeeinflussung des Schichtmaterials erfolgen, dadurch, daß die Substrattemperatur, der Druck der Gase, die Ionisation des Plasmas, die Abscheiderate, die Substratvorspannung beim Sputtern etc. geändert wird. Diese Steuerungsmöglichkeiten sind nur beispielhaft erwähnt.

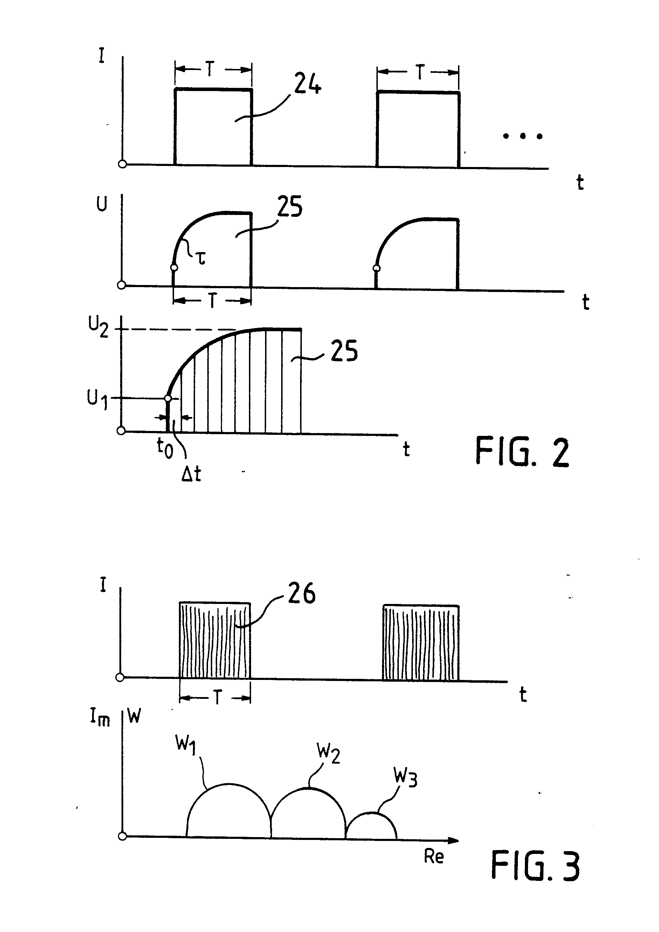

Gemäß Fig. 2 ist das Prüfsignal ein Stromimpuls 24. Dieses Prüfstromimpulse 24 werden der Materialschicht aufgezwungen. Das Meßsignal ist im vorliegenden Falle eine Spannung, die entsprechend dem Materialverhalten einen bestimmten Zeitverlauf aufweist. Während der Dauer T eines solchen Prüf-und Meßsignals können unterschiedliche Zeitkonstanten $\tau$ auftreten, die kennzeichnend sind für z.B. die Kapazitätsänderung, Induktivitätsänderung und/oder die Leitfähigkeitsänderung in der Materialschicht. Weiterhin sind kennzeichnend der Spannungsanfangswert U1 und der Spannungsendwert U2. Die Abtastung des Meßsignals 25 erfolgt in kleinen Zeitintervallen $\Delta t$.

Gemäß Fig. 3 wird als Prüfsignal ein Rauschsignal 26 während einer Zeit T wiederholt angelegt. Als Ergebnis erhält man nach der Auswertung durch die Signalauswertung 20 einen Impedanz-Ortskurvenverlauf W(f), beispielhaft in Figur 3 durch drei Halbkreise angedeutet. Die Ortskurve zeigt die Impedanzwerte mit ihren Real-und Imaginäranteilen.

Die Gesamt-Impedanz-Ortskurve ist aufgeteilt z.B. in 3 Ortskurvenbereiche W1, W2 und W3. Jeder dieser Ortskurvenbereiche ist kennzeichnend für einen bestimmten Leitungsvorgang in der zu untersuchenden Schicht. Diese Ortskurvenbereiche W1 bis W3 sind zeitlich voneinander trennbar und geben daher Aufschluß über die Impedanz-Anteile (Intrinsik-Impedanz, Korngrenzen-Impedanz und Oberflächen-Impedanz).

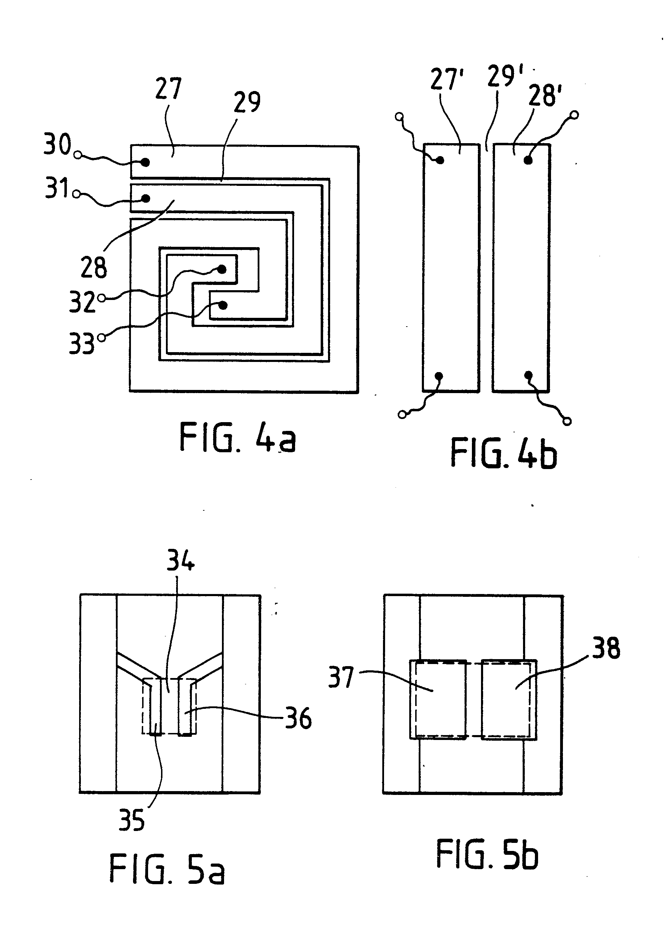

Gemäß Fig. 4a sind zwei Kontaktbereiche 27 und 28 schneckenartig ausgebildet, um einen entsprechend konfigurierten Materialschichtbereich 29 festzulegen. Kontaktanschlüsse sind mit 30, 31, 32 und 33 bezeichnet. Durch diese schmale und besonders lange Ausbildung der Materialschicht ergibt sich der Vorteil einer entsprechenden Verringerung des Impedanz-Widerstandes insbesondere seines Realteiles, was insbesondere bei schlecht leitenden Materialien von Vorteil ist um die Ortskurve entsprechend zu verschieben. In Fig. 4b ist eine Materialschicht 29' mit entsprechender kürzerer Länge und größerer Breite zwischen den Kontaktflächen 27' und 28' gezeigt.

In den Figuren 5a und 5b sind Materialschicht und Kontaktkonfigurationen gezeigt, die bei kapazitiven Materialien von Vorteil sind.

In Fig. 5a ist die wirksame Materialschicht mit 34 bezeichnet. Sie befindet sich zwischen zwei Kontaktflächen 35 und 36. In Fig. 5b sind die Kontaktflächen größer ausgebildet und mit 37 und 38 bezeichnet.

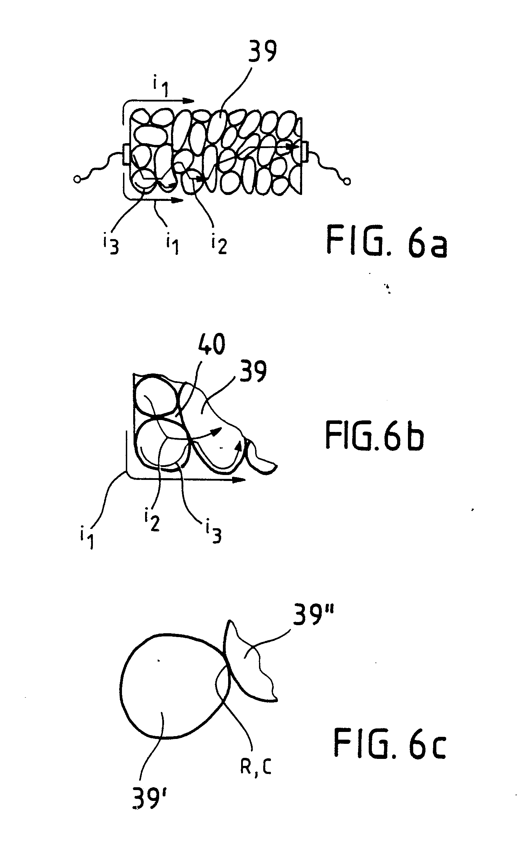

Fig. 6A zeigt den stark vergrößerten Teil einer Materialschicht mit unterschiedlich konfigurierten Partikeln 39. Mit i1 ist der Oberflächenstrom, mit i2 der Intrinsikstrom, der durch die Partikel fließt, und mit i3 der Partikelstrom bezeichnet, der über die Oberflächengrenzen der einzelnen Partikel fließt.

Fig. 6b zeigt einen nochmals vergrößerten Ausschnitt aus Fig. 6a. Die einzelnen Partikel weisen untereinander unterschiedliche Berührungsflächen und an den Stoß-bzw. Berührungsstellen unterschiedliche Übergangswiderstände auf, welches materialabhängig ist. Zwischen einem Teil der Partikel befinden sich winzige Hohlräume 40, die kapazitiven Charakter haben. Die einzelnen Stromanteile i1, i2 und i3 fließen unterschiedlich schnell und haben daher gewöhnlich in Abhängigkeit vom jeweiligen Material unterschiedliche Zeitkonstanten.

Fig. 6c zeigt zwei aneinanderstoßende Partikel 39' und 39". Mit R, C sind der Berührungswiderstand und die Kapazität zwischen diesen beiden Partikeln bezeichnet.

Während der Schichtbildung treten nach wiederholten Messungen Ortskurvenverschiebungen auf, die eine Aussage über die Änderung der Materialeigenschaften geben.

## Ansprüche

1. Verfahren zur reproduzierbaren Bildung von Materialschichten im Wege des Aufdampfens oder Zerstäubens oder der chemischen Abscheidung usw. und/oder zur Behandlung von Materialschichten, insbesondere von Halbleiterschichten durch Diffusion oder Ionenimplantation, wobei während der Schichtbildung zumindest ein Parameter der Materialschicht gemessen und als Meßsignal in einer digitalen Auswerteschaltung zur On-Line-Steuerung des Schichtbildungsprozesses berücksichtigt wird, dadurch **gekennzeichnet,** daß in bestimmten Zeitabständen kurzzeitig ein Prüfsignal (24 oder 26) mit vorgegebenem Verlauf oder Frequenzspektrum oder vorgegebener Frequenzfolge an die Materialschicht angelegt wird, daß in einer Signalauswertung (20) der digitalen Auswerteschaltung aus dem jeweiligen Prüfsignal (Stromsignal) und dem zugeordneten Meßsignal (25, W(f)) (Spannungssignal) zeitlich voneinander trennbare Impedanz-Anteile ($W_1$, $W_2$, $W_3$) ermittelt werden, die untereinander abweichende Werte oder Wertebereiche von Zeitkonstanten und gegebenenfalls zusätzlich von Leitfähigkeiten aufweisen und die insgesamt kennzeichnend sind für den durch sie sich bildende Schicht fließenden Strom, nämlich den Strom durch die homogenen Materialbereiche der Schicht (Intrinsik-Strom $i_2$), den über die Partikel-Grenzflächen (Korngrenzen-Strom $i_3$) fließenden Strom und den über die Schichtoberfläche fließenden Strom (Oberflächenstrom $i_1$).

2. Verfahren nach Anspruch 1, dadurch **gekennzeichnet,** daß das Meßsignal in vorgegebenen Zeitabständen abgetastet wird.

3. Verfahren nach Anspruch 1 oder 2, dadurch **gekennzeichnet,** daß das Prüfsignal ein galvanostatischer Impuls mit definiertem Verlauf ist, der als Stromimpuls der Schicht aufgezwungen wird.

4. Verfahren nach einem der vorhergehenden Ansprüche, dadurch **gekennzeichnet,** daß die Wiederholrate des Prüfsignals abhängig ist von der Schichtbildungsrate.

5. Verfahren nach einem der vorhergehenden Ansprüche, dadurch **gekennzeichnet,** daß die abgetasteten Meßsignalwerte digitalisiert werden und aus dem in der Signalauswertung (20) rekonstruierten Meßsignal charakteristische Größen berechnet und zur Bestimmung der Schicht herangezogen werden.

6. Verfahren nach einem der vorhergehenden Ansprüche, dadurch **gekennzeichnet,** daß die Materialschichtbildung oder Behandlung der Materialschicht auf einem Referenzträger erfolgt und/oder an einer Referenzschicht und daß Soll-Impedanz-Anteilwerte der Materialschicht mit den tatsächlich gemessenen zugeordneten Impedanz-Anteilwerten verglichen werden und daß bei Abweichung einer der Material-Schichtbildungsparameter entsprechend verändert wird.

7. Verfahren nach Anspruch 1 oder 2, dadurch **gekennzeichnet,** daß als Prüfsignal ein Signal mit einem vorgegebenen Frequenzbereich, vorzugsweise ein Rauschsignal, oder eine Signalfolge mit steigender oder fallender Frequenz angelegt wird, und daß die Signalauswertung (20) das digitalisierte Meßsignal auswertet und eine Vielzahl von Impedanzwerten für eine Ortskurve (W (f)) berechnet, sowie die Impedanz-Ortskurven-Werte in Ortskurven-Abschnitte ($W_1$, $W_2$, $W_3$) für gleiche oder nahezu gleiche Zeitkonstanten aufteilt und daß möglichst für jeden der Ortskurven-Abschnitte eine charakteristische Gröse zur Bestimmung der Schicht(en) ermittelt wird.

8. Verfahren nach Anspruch 7, dadurch **gekennzeichnet,** daß die Auswertung der Meßsignale im Wege einer FFT-Analyse (Fast-Fourier-Analyse) erfolgt.

9. Verfahren nach Anspruch 8, dadurch **gekennzeichnet,** daß die berechneten Impedanz-Ortskurven-Werte abgespeichert werden und mit Soll-Impedanz-Ortskurven-Werten eines Musters unter Anwendung eines Korrelations-Algorithmus verglichen werden.

10. Verfahren nach einem der vorhergehenden Ansprüche, dadurch **gekennzeichnet,** daß die Geometrie, die Art, die Anordnung und Fixierung der Elektroden der Muster-Materialschicht an die Größe bzw. an den Größenbereich der Impedanzwerte der zu untersuchenden Materialschicht (Realanteil und Imaginäranteil) angepaßt ist.

11. Verfahren zum Abtragen von Material-Schichten oder Teilen derselben, dadurch **gekennzeichnet,** daß ein oder mehrere Verfahrensschritte der vorhergehenden Ansprüche 1 bis 9 insbesondere bei der Herstellung von steuerbaren Halbleiter-Elementen analog angewendet werden.

12. Verfahren nach einem der Ansprüche 1 bis 11, dadurch **gekennzeichnet,** daß eine unabhängige Montage des Meßsystems am Substrathalter erfolgt und dieses damit frei beweglich ist.

13. Verfahren nach einem der Ansprüche 1 bis 12, dadurch **gekennzeichnet,** daß die Übertragung der Meßdaten mittels eines Telemetrie-Systems zu einem Auswertegerät erfolgt.

14. Verfahren nach Anspruch 13, dadurch **gekennzeichnet,** daß die Ausführung der Telemetrie z. B. im PCM-Verfahren erfolgt.

15. Verfahren nach Anspruch 13 und 14, dadurch **gekennzeichnet,** daß die Übertragung der Telemetrie-Daten mittels Hochfrequenz, mittels Infrarotsignalen, mittels induktiver Kopplung oder mittels kapazitiver Kopplung erfolgt.

16. Verfahren nach einem der Ansprüche 13 bis 15, dadurch **gekennzeichnet,** daß die Anbringung der Antenne für das jeweilige Übertragungsverfahren mittels einer isolierten Vakuumdurchführung innerhalb der Vakuumkammer oder außerhalb der Vakuumkammer unter Ausnutzung entsprechender, nichtabschirmender Öffnungen der Kammer, wie z. B. Glasfenster erfolgt.

17. Verfahren nach Anspruch 13 und 14, dadurch **gekennzeichnet,** daß die Integration des Senders zusammen mit den Meßwertaufnehmern und der Stromversorgung in Miniaturbauweise zu einem unabhängigen Meßsystem erfolgt.

18. Verfahren nach Anspruch 17, dadurch **gekennzeichnet,** daß eine wärmeisolierte Montage des miniaturisierten Meßsystems am beweglichen Substrathalter erfolgt.

19. Verfahren nach Anspruch 17, dadurch **gekennzeichnet,** daß Ausführung des Meßsystems mit derartigen Materialien erfolgt, daß es zu keiner Vakuumverunreinigung kommt.

20. Verfahren nach Anspruch 17, dadurch **gekennzeichnet,** daß die Ausführung des Meßsystems in der Art erfolgt, daß die Bauelemente vakuumdicht gekapselt sind.

21. Verfahren nach Anspruch 13 und 14, dadurch **gekennzeichnet,** daß eine räumliche Trennung der Auswerte-und Sende-Elektronik des Meßsystems von den Meßwertaufnehmern erfolgt, wobei die Verbindung des Meßsystems mit den Meßwertaufnehmern aus festen, leitenden Verbindungen oder aus lösbaren Verbindungen, z. B. Federkontakten bestehen kann.

22. Verfahren nach einem der Ansprüche 12 bis 21, dadurch gekennzeichnet, daß die Meßsignale im Meßsystem digitalisiert werden und die Übertragung zur Auswerteschaltung im Takt der Digitalisierung erfolgt und die Auswertung in einem externen Auswertegerät erfolgt.

23. Verfahren nach einem der Ansprüche 12 bis 21, dadurch **gekennzeichnet,** daß die Meßsignale im Meßsystem digitalisiert werden und bis zur Übertragung zur Auswerteschaltung im Meßsystem zwischengespeichert werden, um danach in einem langsameren Takt zur Auswertung in einem externen Auswertegerät übertragen zu werden.

24. Verfahren nach einem der Ansprüche 12 bis 21, dadurch **gekennzeichnet,** daß die im Meßsystem digitalisierten Meßsignale direkt im Meßsystem ausgewertet werden die Übertragung zur Auswerteschaltung nur noch die Ergebnisse der Messung umfaßt.

25. Verfahren nach einem der Ansprüche 1 bis 24, dadurch **gekennzeichnet,** daß die Anregungssignale für die verschiedenen Meßverfahren im beweglichen Meßsystem autonom erzeugt werden.

26. Verfahren nach einem der Ansprüche 1 bis 25, dadurch **gekennzeichnet,** daß die Ermittlung der Prozeßtemperatur über ein Thermoelementepaar erfolgt.

27. Verfahren nach Anspruch 26, dadurch **gekennzeichnet,** daß für das Thermoelementepaar die Benutzung einer relativ isothermen Fläche innerhalb oder außerhalb der Vakuumkammer als Referenzpunkt herangezogen wird.

28. Verfahren nach Anspruch 26, dadurch **gekennzeichnet,** daß für das Thermoelementepaar die Benutzung einer elektronischen Temperaturkonstanthaltung, die innerhalb oder außerhalb des Meßsystems ausgebildet sein kann, herangezogen wird.

29. Verfahren nach Anspruch 26, dadurch **gekennzeichnet,** daß für das Thermoelementepaar bei zeitlich kurzen Beschichtungsvorgängen die Benutzung der dem Prozeß abgewandten Seite des Meßsystems unter Ausnutzung der thermischen Trägheit als Referenzpunkt herangezogen wird.

30. Verfahren nach Anspruch 26, dadurch **gekennzeichnet,** daß für das Thermoelementepaar die Benutzung einer zwangsgekühlten Stelle des Substrathalters als Referenzpunkt herangezogen wird.

31. Verfahren nach einem der Ansprüche 12 bis 30, dadurch **gekennzeichnet,** daß die Speisung des frei beweglichen Meßsystems mit Versorgungsspannungen über Federkontakte erfolgt, die am Substratträger angebracht sind.

32. Verfahren nach einem der Ansprüche 12 bis 30, dadurch **gekennzeichnet,** daß die Speisung des frei beweglichen Meßsystems mit Versorgungsspannungen über Solarzellen erfolgt, die entweder über das Plasmaleuchten oder über zusätzliche Lichtquellen gespeist werden.

33. Verfahren nach einem der Ansprüche 12 bis 30, dadurch **gekennzeichnet,** daß die Speisung des frei beweglichen Meßsystems mit Versorgungsspannungen über HF-Energie erfolgt, die entweder aus dem HF-Spektrum des Beschichtungsvorganges oder aber aus einer zusätzlichen HF-Spule zu Verfügung gestellt wird.

34. Verfahren nach einem der Ansprüche 12 bis 30, dadurch **gekennzeichnet,** daß die Speisung des frei beweglichen Meßsystems mit Versorgungsspannungen über Primär-Batterien oder wiederaufladbare Akkumulatoren erfolgt.

35. Verfahren nach einem der Ansprüche 1 bis 34, dadurch **gekennzeichnet,** uaß die Darstellung der Ergebnisse der Meßverfahren noch während des Prozeßverlaufes auf einem Anzeigemedium, z. B. Bildschirm erfolgt.

36. Verfahren nach einem der Ansprüche 1 bis 35, dadurch **gekennzeichnet,** daß die Darstellung der Ergebnisse aus der Berechnung der Differenz der in situ Ergebnisse mit gespeicherten Referenzkurven aus einem früheren Prozeßablauf und die Anzeige dieser Differenz auf einem Anzeigemedium, z. B. Bildschirm erfolgt.

37. Verfahren nach einem der Ansprüche 1 bis 36, dadurch **gekennzeichnet,** daß die Kopplung der Meßverfahren mit einem Prozeßrechner zum Zwecke der Prozeßkontrolle oder Prozeßsteuerung bzw. Prozeßregelung erfolgt.

38. Verfahren nach einem der Ansprüche 1 bis 37, dadurch **gekennzeichnet,** daß die Abdeckung des Meßwertaufnehmers mit einer Referenzöffnung erfolgt, die es ermöglicht, eine partielle Beschichtung bzw. Abtragung des Aufnehmers zu erreichen.

39. Verfahren nach einem der Ansprüche 1 bis 38, dadurch **gekennzeichnet,** daß zur Vermeidung des störenden Einflusses des Plasmas bei dynamischen Prozessen, bei denen der Substrathalter nur jeweils kurzzeitig durch das Plasma bewegt wird, die Messung außerhalb des direkten Plasmaeinflusses erfolgt.

40. Verfahren nach einem der Ansprüche 1 bis 39, dadurch **gekennzeichnet,** daß die beim HF-Sputtern auftretenden Frequenzen aus den Signalen der Meßwertaufnehmer ausgefiltert werden.

41. Verfahren nach einem der Ansprüche 1 bis 40, dadurch **gekennzeichnet,** daß die Ausbildung des Meßwertaufnehmers in Form eines nichtleitenden Plättchens, z. B. Glas, mit angebrachten bzw. auflithographierten Kontakten zur Abnahme der erwarteten MeßgrAßen erfolgt.

42. Verfahren nach einem der Ansprüche 1 bis 40, dadurch **gekennzeichnet,** daß bei der Ermittlung von Abtragvorgängen der Meßwertaufnehmer zuvor mit einer Referenzschicht, die der abzutragenden Schicht entspricht, versehen wird.

43. Verfahren nach einem der Ansprüche 1 bis 40, dadurch **gekennzeichnet,** daß bei der Behandlung oder Veränderung von Oberflächen durch Plasma-, Implantations-und Ionenstrahlbehandlung das Referenzsubstrat eingesetzt wird, das dem zu behandelnden Material entspricht.

44. Verfahren nach einem der vorhergehenden Ansprüche, dadurch **gekennzeichnet,** daß die Elektrodeanordnung dem zu untersuchenden Schichteffekt angepaßt ist.

45. Verfahren nach Anspruch 44, dadurch **gekennzeichnet,** daß während der Schichtbildung auf eine andere Elektrodenanordnung umgeschaltet wird, um andere Schichteffekte zu messen.

**FIG. 1a**

Labels in figure: 6, 5, 4, 3, 7, 2, 8, 1, $^T$Ref, $^T$Ist, VORFILTERUNG — 10, 9, ABTASTUNG UND SPEICHERUNG — 11, 12, A / D — 13, PCM-MODULATOR — 14, HF-SENDER — 15, 16

10 229

FIG.1b

10 229

FIG. 2

FIG. 3

10 229

FIG. 4a

FIG. 4b

FIG. 5a

FIG. 5b

10 229

$i_1$
39

$i_3$  $i_1$  $i_2$

FIG. 6a

40
39

$i_1$  $i_2$  $i_3$

FIG.6b

39"

39'  R,C

FIG. 6c

10 229